# EUROPEAN PATENT APPLICATION

(11) **EP 4 447 111 A1**
(43) Date of publication of application: **16.10.2024**
(21) Application number: 22904374.0
(22) Date of filing: 13.07.2022
(51) Int. Cl.: H01L 27/12

(54) **DISPLAY DEVICE COMPRISING SEMICONDUCTOR LIGHT-EMITTING ELEMENT, AND MANUFACTURING METHOD THEREFOR**

(30) Priority: 08.12.2021 KR 20210174394
(71) Applicant: LG Electronics Inc., Yeongdeungpo-gu Seoul 07336 (KR); LG Display Co., Ltd., Seoul 07336 (KR)
(72) Inventor: KIM, Sunho, Seoul 06772 (KR); KIM, Jungmin, Paju-si Gyeonggi-do 10845 (KR); HONG, Gisang, Paju-si Gyeonggi-do 10845 (KR); NAM, Kyoungjin, Paju-si Gyeonggi-do 10845 (KR); LEE, Youngwook, Paju-si Gyeonggi-do 10845 (KR)
(74) Representative: Vossius & Partner Patentanwälte Rechtsanwälte mbB
(86) International application number: PCT/KR2022/010213
(87) International publication number: WO 2023/106537

(57) **Abstract**

A display device and a method of manufacturing the same according to an embodiment include a substrate, first assembly wiring and second assembly wiring alternately arranged on the substrate, a first insulating layer disposed between the first assembly wiring and the second assembly wiring, a planarization layer disposed on the first assembly wiring and the second assembly wiring, and having a first opening, and a light emitting element disposed inside the first opening, wherein the first electrode overlaps the first assembly wiring and the second assembly wiring. And, the first electrode is in contact with one of the first assembly wiring and the second assembly wiring, and the second assembly wiring includes a transparent conductive layer.

## Description

### [Technical Field]

The embodiment relates to a display device and a method of manufacturing the same, and more specifically, to a display device using an LED (Light Emitting Diode) and a method of manufacturing the same.

### [Background Art]

Display devices used in computer monitors, TVs, mobile phones, etc. include Organic Light Emitting Display (OLED), which emits light on its own, and Liquid Crystal Display (LCD), which requires a separate light source. Micro-LED, etc.

Micro-LED display is a display that uses micro-LED, a semiconductor light emitting device with a diameter or cross-sectional area of 100*µ*m or less, as a display element.

Micro-LED displays use micro-LED, a semiconductor light emitting device, as a display device, so they have excellent performance in many characteristics such as contrast ratio, response speed, color gamut, viewing angle, brightness, resolution, lifespan, luminous efficiency, and luminance.

In particular, the micro-LED display has the advantage of being able to freely adjust the size and resolution and implement a flexible display because the screen may be separated and combined in a modular manner.

However, because large micro-LED displays require more than millions of micro-LEDs, there is a technical problem that makes it difficult to quickly and accurately transfer micro-LEDs to the display panel. Meanwhile, methods for transferring a semiconductor light emitting device to a substrate include a pick and place process, a laser lift-off method, or a self-assembly method.

Among these, the self-assembly method is a method in which the semiconductor light emitting device finds its assembly position within the fluid on its own, and is an advantageous method for implementing a large-screen display device.

Meanwhile, when transferring a light emitting device in a fluid, a problem arises where the assembly wiring is corroded by the fluid. Corrosion of the assembly wiring may cause an electrical short circuit and cause assembly defects. In addition, if the assembly force for the light emitting device is insufficient during self-assembly, problems with assembly defects may occur, so technology to improve assembly force is needed.

### [Disclosure]

### [Technical Problem]

The technical task of the embodiment is to provide a display device and a manufacturing method thereof that improve the assembly rate of the light emitting device by precisely forming the first and second assembly lines in the pocket area where the light emitting device is disposed.

In addition, the technical problem of the embodiment is to provide a display device that may use assembly wiring as a pixel electrode for driving a light emitting device and a method of manufacturing the same.

The tasks of the embodiment are not limited to the tasks mentioned above and include those that may be understood from the specification.

### [Technical Solution]

A display device including a semiconductor light emitting device according to an embodiment include a substrate, first assembly wiring and second assembly wiring alternately arranged on the substrate, a first insulating layer disposed between the first assembly wiring and the second assembly wiring, a planarization layer disposed on the first assembly wiring and the second assembly wiring and having a first opening, and a light emitting device disposed inside the first opening, wherein a first electrode overlaps the first assembly wiring and the second assembly wiring. The first electrode contacts one of the first assembly wiring and the second assembly wiring, and the second assembly wiring may include a transparent conductive layer.

Additionally, in an embodiment, the first assembly wiring and the second assembly wiring may have no gap between them, or the second assembly wiring may have a structure spanning an edge portion of the first assembly wiring.

The first assembly wiring is below the first insulating layer, and the second assembly wiring may include a second clad layer spaced apart from the first assembly wiring, and a third clad layer in contact with the second clad layer and disposed in the first opening in parallel with the second clad layer or on the second clad layer.

The first assembly wiring may include a first conductive layer disposed on the substrate; and a first clad layer in contact with the first conductive layer, wherein the second assembly wiring may include a second conductive layer disposed on the first insulating layer; a second clad layer in contact with the second conductive layer; And a third clad layer in contact with the second clad layer, and the first electrode may be in contact with the third clad layer.

The first conductive layer and the second conductive layer may overlap the planarization layer, a portion of each of the first clad layer and the second clad layer may be disposed inside the first opening, and the third clad layer may be disposed inside the first opening.

The third clad layer may vertically overlap the first clad layer.

The third clad layer may be a transparent conductive layer.

The first assembly wiring may include a first conductive layer disposed on the substrate, and a first clad layer in contact with the first conductive layer, the second assembly wiring includes a second clad layer disposed on the first insulating layer, and a second conductive layer in contact with the second clad layer.

The second clad layer may be in contact with the first electrode of the light emitting device.

The first conductive layer and the second conductive layer overlap the planarization layer, and a portion of each of the first clad layer and the second clad layer may be disposed inside the first opening.

The second clad layer may be a transparent conductive layer.

The first clad layer may be in contact with the first electrode of the light emitting device.

Embodiment may further include a second insulating layer in contact with the lower surface of the first clad layer and the side surface of the second clad layer, and a third insulating layer in contact with the upper surface of the second clad layer and the side surface of the first clad layer.

The first clad layer and the second clad layer may not overlap each other in the vertical and horizontal directions.

The third insulating layer may be located between the second conductive layer and the second clad layer.

In addition, a method of manufacturing a display device including a semiconductor light emitting device according to an embodiment include forming a first assembly wiring on a substrate; forming an insulating layer on the first assembly wiring; forming a second assembly wiring on the insulating layer to be spaced apart from the first assembly wiring, forming a planarization layer to expose a portion of the second assembly wiring, and bonding the light emitting device to be in contact with the second assembly wiring. Forming the second assembly wiring may include depositing a transparent conductive layer on the insulating layer, irradiating light from the back of the substrate toward the transparent conductive layer, and removing the transparent conductive layer that is not irradiated with light.

In addition, in the embodiment, forming the second assembly wiring includes forming a second conductive layer on the insulating layer; forming a second clad layer completely covering the second conductive layer; and forming a third clad layer through the transparent conductive layer.

The second clad layer has no separation distance from the first assembly wiring and the second clad layer and may contact a side surface of the second clad layer.

Forming the first assembly wiring may include forming a first conductive layer on the substrate, and forming a first clad layer that completely covers the first conductive layer.

Forming the second assembly wiring may include forming a second clad layer through the transparent conductive layer, and forming a second conductive layer on the second clad layer.

### [Advantageous Effects]

According to the embodiment, there is a technical effect in that the wiring for self-assembly of the light emitting device may also be used as a wiring for driving the light emitting device.

In addition, the embodiment implements a part of the second assembly wiring using a transparent conductive layer to eliminate the process margin caused by separating the first assembly wiring and the second assembly wiring from each other, there is a technical effect of precisely controlling the gap between the first assembly wiring and the second assembly wiring and improving the transfer rate of the light emitting device.

In addition, the embodiment forms one of the layers constituting the first assembly wiring and the second assembly wiring using a back exposure process, there is a technical effect of precisely adjusting the gap between the first assembly wiring and the second assembly wiring and improving the assembly rate of the light emitting device.

In addition, the embodiment has the technical effect of improving the assembly force of the light emitting device by arranging the first assembly wiring and the second assembly wiring closer together.

The effects according to the embodiment are not limited to the contents exemplified above, and more diverse effects are included in the specification.

### [Description of Drawings]

FIG. 1 is a schematic plan view of a display device according to an embodiment.
FIG. 2 is a schematic enlarged plan view of a display device according to an embodiment.
FIG. 3 is a cross-sectional view of a display device according to an embodiment.
FIGS. 4A to 4C are process diagrams for explaining a manufacturing method of a display device according to an embodiment.
FIG. 5 is a cross-sectional view of a display device according to a second embodiment.
FIGS. 6A to 6H are process diagrams for explaining a method of forming assembly wiring for a display device according to the second embodiment.
FIG. 6I is a modified example of assembly wiring of a display device according to the second embodiment.
FIG. 7 is a cross-sectional view of a display device according to a third embodiment.
FIGS. 8A to 8E are process charts for explaining the manufacturing method of the display device according to the third embodiment.
FIG. 9 is a cross-sectional view of a display device according to the fourth embodiment.

### [Mode for Invention]

Hereinafter, embodiments disclosed in this specification will be described in detail with reference to the attached drawings. The suffixes 'module' and 'part' for components used in the following description are given or used interchangeably in consideration of ease of specification preparation, and do not have distinct meanings or roles in themselves. In addition, the attached drawings are intended to facilitate easy understanding of the embodiments disclosed in this specification, and the technical ideas disclosed in this specification are not limited by the attached drawings. Additionally, when an element such as a layer, region or substrate is referred to as being 'on' another component, this includes either directly on the other element or there may be other intermediate elements in between.

Display devices described in this specification include digital TVs, mobile phones, smart phones, laptop computers, digital broadcasting terminals, PDAs (personal digital assistants), PMP (portable multimedia player), navigation, Slate PC, Tablet PC, Ultra-Book, desktop computer, etc. However, the configuration according to the embodiment described in this specification may be applied to a device capable of displaying even if it is a new product type that is developed in the future.

Hereinafter, an embodiment will be described with reference to the drawings.

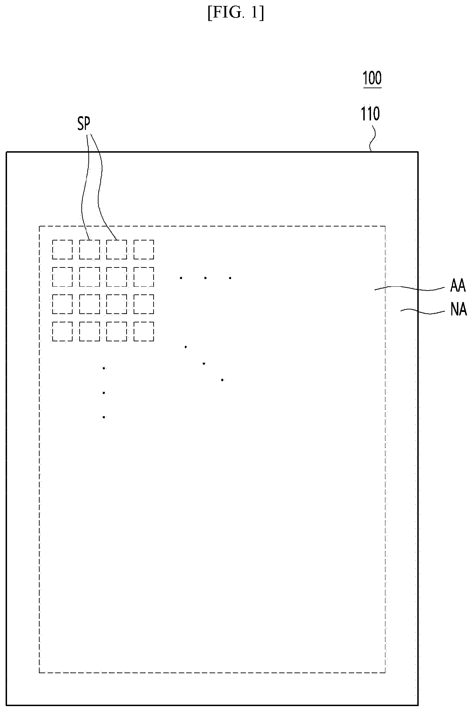

FIG. 1 is a schematic plan view of a display device according to an embodiment. For convenience of explanation, only the substrate 110 and the plurality of sub-pixels (SP) among the various components of the display device 100 are shown in FIG. 1.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the light emission of unit pixels arranged in a matrix form. A unit pixel refers to the minimum unit for implementing one color. A unit pixel of a flexible display may be implemented by a light emitting device. In the embodiment, the light emitting device may be Micro-LED or Nano-LED, but is not limited thereto.

The substrate 110 is configured to support various components included in the display device 100, and may be made of an insulating material. For example, the substrate 110 may be made of glass or resin. Additionally, the substrate 110 may include polymer or plastic, or may be made of a material with flexibility.

The substrate 110 includes a display area (AA) and a non-display area (NA).

The display area (AA) is an area where a plurality of sub-pixels (SP) are arranged and an image is displayed. Each of the plurality of sub-pixels (SP) is an individual unit that emits light, and a light emitting device 130 and a driving circuit are formed in each of the plurality of sub-pixels (SP). For example, the plurality of sub-pixels SP may include, but are not limited to, a red sub-pixel, a green sub-pixel, a blue sub-pixel, and/or a white sub-pixel. Hereinafter, the description will be made on the assumption that the plurality of sub-pixels SP includes a red sub-pixel, a green sub-pixel, and a blue sub-pixel, but is not limited thereto.

The non-display area (NA) is an area where images are not displayed, and is an area where various wiring, driver ICs, etc. for driving the sub-pixels (SP) arranged in the display area (AA) are placed. For example, various ICs, such as gate driver ICs and data driver ICs, and driving circuits may be placed in the non-display area (NA). Meanwhile, the non-display area NA may be located on the back of the substrate 110, that is, on the side without the sub-pixel SP, or may be omitted, and is not limited to what is shown in the drawing.

The display device 100 of the embodiment may drive the light emitting device in an active matrix (AM, Active Matrix) method or a passive matrix (PM, Passive Matrix) method.

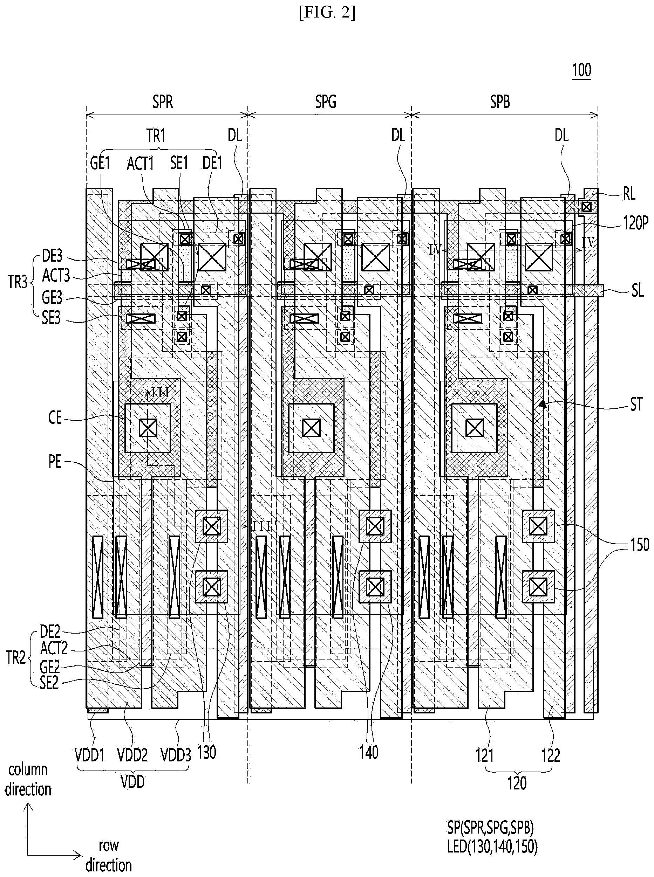

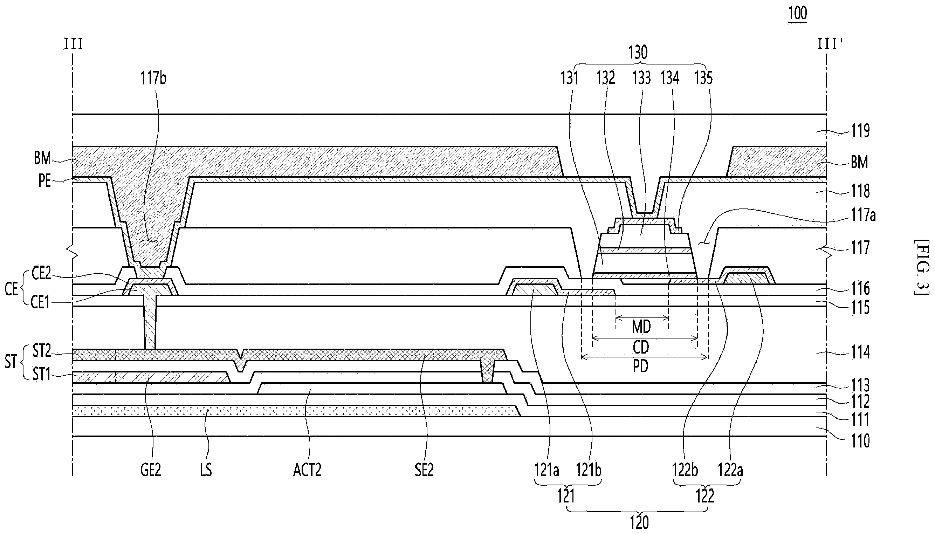

Hereinafter, FIGS. 2 and 3 will be referred to together for a more detailed description of the plurality of sub-pixels (SP).

FIG. 2 is a schematic enlarged plan view of a display device according to an embodiment. FIG. 3 is a cross-sectional view taken along line III-III' of FIG. 2. 2 and 3, the display device 100 according to an embodiment of the present invention include a plurality of scan wires (SL), a plurality of data wires (DL), a plurality of high potential power supply wires (VDD), a plurality of assembly wirings 120, a first transistor (TR1), a second transistor (TR2), and a third transistor (TR3) of each of the plurality of reference lines (RL) and the black matrix (BM) and the plurality of sub-pixels (SP), a storage capacitor (ST), a semiconductor light emitting device (LED), a light blocking layer (LS), a buffer layer 111, a gate insulating layer 112, a plurality of passivation layers 113, 115, 116, a plurality of planarization layers (114, 117, 118), connection electrodes (CE), pixel electrodes (PE), etc.

Referring to FIGS. 2 and 3, a plurality of data lines (DL), a first layer (VDD1) and a second layer (VDD2) of the high-potential power line (VDD), a plurality of reference lines (RL), and The plurality of assembly wirings 120 may extend in the column direction between the plurality of sub-pixels SP, and the third layer VDD3 of the plurality of scan lines SL and the high potential power line VDD may extend in the row direction between the plurality of sub-pixels SP. Additionally, the first transistor TR1, second transistor TR2, third transistor TR3, and storage capacitor ST may be disposed in each of the plurality of sub-pixels SP.

First, the first layer (VDD1) and the light blocking layer (LS) of the high-potential power supply line (VDD) may be disposed on the substrate 110.

The high-potential power supply line (VDD) is a line that transmits a high-potential power supply voltage to each of a plurality of sub-pixels (SP). A plurality of high-potential power supply lines (VDD) may transmit a high-potential power supply voltage to the second transistor TR2 of each of the plurality of sub-pixels (SP).

Meanwhile, a plurality of high-potential power supply lines (VDDs) may be made of a single layer or multiple layers, hereinafter, for convenience of explanation, the description will be made on the assumption that a plurality of high-potential power supply lines (VDDs) are composed of a plurality of layers.

The high potential power line (VDD) may include a plurality of first layers (VDD1), a plurality of second layers (VDD2), and a plurality of third layers (VDD3) connecting them. The first layer VDD1 may extend in the column direction between each of the plurality of sub-pixels SP.

A light blocking layer LS may be disposed in each of the plurality of sub-pixels SP on the substrate 110. The light blocking layer LS blocks light incident from the lower part of the substrate 110 to the second active layer ACT2 of the second transistor TR2, which will be described later, and may prevent deterioration of the second transistor TR2.

The buffer layer 111 is disposed on the first layer (VDD1) and the light blocking layer (LS) of the high-potential power supply line (VDD). The buffer layer 111 may reduce penetration of moisture or impurities through the substrate 110. The buffer layer 111 may be composed of, for example, a single layer or a multiple layer of silicon oxide (SiOx) or silicon nitride (SiNx), but is not limited thereto. However, the buffer layer 111 may be omitted depending on the type of substrate 110 or the type of transistor, but is not limited thereto.

A plurality of scan wires (SL), a plurality of reference wires (RL), a plurality of data wires (DL), a first transistor (TR1), a second transistor (TR2), a third transistor (TR3), and a storage capacitor (ST) may be disposed on the buffer layer 111.

First, the first transistor TR1 may be disposed in each of the plurality of sub-pixels SP. The first transistor TR1 includes a first active layer ACT1, a first gate electrode GE1, a first source electrode SE1, and a first drain electrode DE1. The first active layer ACT1 may be disposed on the buffer layer 111. The first active layer ACT1 may be made of a semiconductor material such as oxide semiconductor, amorphous silicon, or polysilicon, but is not limited thereto.

The gate insulating layer 112 may be disposed on the first active layer ACT1. The gate insulating layer 112 is an insulating layer for insulating the first active layer (ACT1) and the first gate electrode (GE1), and may be composed of a single layer or multiple layers of silicon oxide (SiOx) or silicon nitride (SiNx), but is not limited to this.

The first gate electrode GE1 may be disposed on the gate insulating layer 112. The first gate electrode GE1 may be electrically connected to the scan line SL. The first gate electrode GE1 may be made of a conductive material, such as copper (Cu), aluminum (Al), molybdenum (Mo), nickel (Ni), titanium (Ti), chromium (Cr), or an alloy thereof, but is not limited to this.

The first passivation layer 113 may be disposed on the first gate electrode GE1. Contact holes are formed in the first passivation layer 113 to connect the first source electrode SE1 and the first drain electrode DE1 to the first active layer ACT1. The first passivation layer 113 is an insulating layer to protect the structure below the first passivation layer 113, and may be composed of a single layer or multiple layers of silicon oxide (SiOx) or silicon nitride (SiNx), but is not limited thereto.

A first source electrode (SE1) and a first drain electrode (DE1) electrically connected to the first active layer (ACT1) may be disposed on the first passivation layer 113. The first drain electrode DE1 may be connected to the data line DL, and the first source electrode SE1 may be connected to the second gate electrode GE2 of the second transistor TR2. The first source electrode (SE1) and the first drain electrode (DE1) are made of a conductive material, such as copper (Cu), aluminum (Al), molybdenum (Mo), nickel (Ni), titanium (Ti), chromium ( Cr) or an alloy thereof, but is not limited thereto.

Meanwhile, in the embodiment, the first source electrode (SE1) and the first drain electrode (DE1) were described as being connected to the second gate electrode (GE2) and the data line (DL), respectively, but depending on the type of transistor, the first source electrode SE1 may be connected to the data line DL, and the first drain electrode DE1 may be connected to the second gate electrode GE2 of the second transistor TR2, but is not limited to this.

The first gate electrode GE1 of the first transistor TR1 is connected to the scan line SL and may be turned on or off depending on the scan signal. The first transistor TR1 may transmit a data voltage to the second gate electrode GE2 of the second transistor TR2 based on the scan signal, and may be referred to as a switching transistor.

Meanwhile, a plurality of data lines DL and a plurality of reference lines RL may be disposed on the gate insulating layer 112 along with the first gate electrode GE1. The plurality of data lines DL and the reference lines RL may be formed of the same material and process as the first gate electrode GE1.

The plurality of data lines DL are lines that transmit data voltages to each of the plurality of sub-pixels SP. The plurality of data lines DL may transmit data voltage to the first transistor TR1 of each of the plurality of sub-pixels SP. For example, a plurality of data lines (DL) may consist of a data line (DL) that delivers the data voltage to the red sub-pixel (SPR), a data line (DL) that delivers the data voltage to the green sub-pixel (SPG), and a data line (DL) that transmits data voltage to the blue sub-pixel (SPB).

The plurality of reference wires RL are wires that transmit a reference voltage to each of the plurality of sub-pixels SP. The plurality of reference lines RL may transmit a reference voltage to the third transistor TR3 of each of the plurality of sub-pixels SP.

The second transistor TR2 may be disposed in each of the plurality of sub-pixels SP. The second transistor TR2 includes a second active layer ACT2, a second gate electrode GE2, a second source electrode SE2, and a second drain electrode DE2. A second active layer (ACT2) is disposed on the buffer layer 111. The second active layer (ACT2) may be made of a semiconductor material such as oxide semiconductor, amorphous silicon, or polysilicon, but is not limited thereto.

The gate insulating layer 112 may be disposed on the second active layer ACT2, and the second gate electrode GE2 may be disposed on the gate insulating layer 112. The second gate electrode GE2 may be electrically connected to the first source electrode SE1 of the first transistor TR1. The second gate electrode GE2 may be made of a conductive material, such as copper (Cu), aluminum (Al), molybdenum (Mo), nickel (Ni), titanium (Ti), chromium (Cr), or an alloy thereof, but is not limited to this.

The first passivation layer 113 is disposed on the second gate electrode (GE2), and the second source electrode (SE2) and the second drain electrode (DE2) are disposed on the first passivation layer 113. The second source electrode SE2 is electrically connected to the second active layer ACT2. The second drain electrode DE2 is electrically connected to the second active layer ACT2 and at the same time is electrically connected to the high potential power supply line VDD. The second drain electrode DE2 may be disposed between the first layer VDD1 and the second layer VDD2 of the high potential power line VDD and electrically connected to the high potential power line VDD.

The second transistor TR2 has a second gate electrode GE2 connected to the first source electrode SE1 of the first transistor TR1, so that when the first transistor TR1 is turned on, it may be turned on by the data voltage transmitted. And the turned-on second transistor TR2 may transfer a driving current to the light emitting device (LED) based on the high-potential power supply voltage from the high-potential power supply line (VDD), and thus may be referred to as a driving transistor.

The third transistor TR3 may be disposed in each of the plurality of sub-pixels SP. The third transistor TR3 includes a third active layer ACT3, a third gate electrode GE3, a third source electrode SE3, and a third drain electrode DE3. The third active layer (ACT3) may be disposed on the buffer layer 111. The third active layer (ACT3) may be made of a semiconductor material such as oxide semiconductor, amorphous silicon, or polysilicon, but is not limited thereto.

The gate insulating layer 112 may be disposed on the third active layer ACT3, and the third gate electrode GE3 may be disposed on the gate insulating layer 112. The third gate electrode GE3 is connected to the scan line SL, and the third transistor TR3 may be turned on or off by the scan signal. The third gate electrode GE3 is made of a conductive material, such as copper (Cu), aluminum (Al), molybdenum (Mo), nickel (Ni), titanium (Ti), chromium (Cr), or an alloy thereof, but is not limited to this.

However, it was explained that the third gate electrode (GE3) and the first gate electrode (GE1) were connected to the same scan line (SL), but the third gate electrode GE3 may be connected to a different scan line SL from the first gate electrode GE1, but is not limited thereto.

The first passivation layer 113 is disposed on the third gate electrode GE3, and the third source electrode SE3 and the third drain electrode DE3 are disposed on the first passivation layer 113. The third source electrode (SE3) is formed integrally with the second source electrode (SE2), may be electrically connected to the third active layer (ACT3) and simultaneously to the second source electrode (SE2) of the second transistor (TR2). And the third drain electrode DE3 may be electrically connected to the reference wiring RL.

The third transistor (TR3), which is electrically connected to the second source electrode (SE2), reference wiring (RL), and storage capacitor (ST) of the second transistor (TR2), which is a driving transistor, may be referred to as a sensing transistor.

A storage capacitor (ST) may be disposed in each of the plurality of sub-pixels (SP). The storage capacitor ST includes a first capacitor electrode ST1 and a second capacitor electrode ST2. The storage capacitor ST is connected between the second gate electrode GE2 and the second source electrode SE2 of the second transistor TR2, and stores voltage and may maintain the voltage level of the gate electrode of the second transistor TR2 constant while the light emitting device (LED) emits light.

The first capacitor electrode ST1 may be integrated with the second gate electrode GE2 of the second transistor TR2. Accordingly, the first capacitor electrode ST1 may be electrically connected to the second gate electrode GE2 of the second transistor TR2 and the first source electrode SE1 of the first transistor TR1.

The second capacitor electrode (ST2) may be disposed on the first capacitor electrode (ST1) with the first passivation layer 113 interposed therebetween. The second capacitor electrode ST2 may be integrated with the second source electrode SE2 of the second transistor TR2 and the third source electrode SE3 of the third transistor TR3. Accordingly, the second capacitor electrode ST2 may be electrically connected to the second transistor TR2 and the third transistor TR3.

Meanwhile, the plurality of scan wires SL may be disposed on the first passivation layer 113 with first source electrode (SE1), first drain electrode (DE1), second source electrode (SE2), second drain electrode (DE2), third source electrode (SE3), third drain electrode (DE3) and second Capacitor electrode (ST2).

The plurality of scan wires (SL) are wires that transmit scan signals to each of the plurality of sub-pixels (SP). The plurality of scan lines SL may transmit scan signals to the first transistor TR1 of each of the plurality of sub-pixels SP. For example, each of the plurality of scan lines SL extends in the row direction and may transmit a scan signal to a plurality of sub-pixels SP arranged in the same row.

Next, the first planarization layer 114 may be disposed on the a plurality of scan wires (SL), a plurality of reference wires (RL), a plurality of data wires (DL), a first transistor (TR1), a second transistor (TR2), a third transistor (TR3), and a storage capacitor (ST). The first planarization layer 114 may planarize the upper part of the substrate 110 on which the plurality of transistors are disposed. The first planarization layer 114 may be composed of a single layer or a double layer, and may be made of, for example, an acryl-based organic material, but is not limited thereto.

The second passivation layer 115 may be disposed on the first planarization layer 114. The second passivation layer 115 is an insulating layer for protecting the structure below the second passivation layer 115 and improving the adhesion of the structure formed on the second passivation layer 115, and may be composed of a single layer or multiple layers of silicon oxide (SiOx) or silicon nitride (SiNx), but is not limited thereto.

The second layer (VDD2) of the high-potential power supply wiring (VDD), the plurality of first assembly wirings 121 among the plurality of assembly wiring lines 120, and the connection electrode (CE) may be disposed on the second passivation layer 115.

First, the plurality of assembly wirings 120 is a wiring that generate an electric field for aligning the plurality of light emitting devices (LEDs) when manufacturing the display device 100 and supplies a low-potential power supply voltage to a plurality of light emitting devices (LEDs) when the display device 100 is driven. Accordingly, the assembly wiring 120 may be referred to as a low-potential power wiring. The plurality of assembly wirings 120 are arranged in a column direction along the plurality of sub-pixels SP arranged on the same line. The plurality of assembly wirings 120 may be arranged to overlap the plurality of sub-pixels SP arranged in the same column. For example, one first assembly wiring 121 and a second assembly wiring 122 are disposed in a red sub-pixel (SPR) arranged in the same row, one first assembly wiring 121 and a second assembly wiring 122 are disposed in the green sub-pixel (SPG), and one first assembly wiring 121 and a second assembly wiring 122 may be disposed in the blue sub-pixel (SPB).

The plurality of assembly wiring lines 120 may include a plurality of first assembly wiring lines 121 and a plurality of second assembly wiring lines 122. When the display device 100 is driven, the same low-potential voltage may be applied to the plurality of first assembly wirings 121 and the plurality of second assembly wirings 122 in alternating current. The plurality of first assembly wirings 121 and the plurality of second assembly wirings 122 may be alternately arranged. Additionally, in each of the plurality of sub-pixels SP, one first assembly wiring 121 and one second assembly wiring 122 may be disposed adjacent to each other.

The plurality of first assembly wirings 121 and the plurality of second assembly wirings 122 may be made of a conductive material, for example, copper (Cu) and chromium (Cr), but are not limited thereto.

The plurality of first assembly wirings 121 include a first conductive layer 121a and a first clad layer 121b. The first conductive layer 121a may be disposed on the second passivation layer 115. The first clad layer 121b may be in contact with the first conductive layer 121a. For example, the first clad layer 121b may be disposed to cover the top and side surfaces of the first conductive layer 121a. And the first conductive layer 121a may have a thickness greater than that of the first clad layer 121b.

The first clad layer (121b) is made of a material that is more resistant to corrosion than the first conductive layer (121a), when manufacturing the display device 100, short circuit defects due to migration of the first conductive layer 121a of the first assembly wiring 121 and the second conductive layer 122a of the second assembly wiring 122 are minimized. For example, the first clad layer 121b may be made of molybdenum (Mo), molybdenum titanium (MoTi), etc., but is not limited thereto.

The second layer (VDD2) of the high potential power line (VDD) may be disposed on the second passivation layer (115). The second layer (VDD2) extends in the column direction between each of the plurality of sub-pixels (SP) and may overlap the first layer (VDD1). The first layer (VDD1) and the second layer (VDD2) may be electrically connected through a contact hole formed in the insulating layers formed between the first layer (VDD1) and the second layer (VDD2). The second layer VDD2 may be formed of the same material and process as the first assembly wiring 121, but is not limited thereto.

A connection electrode (CE) is disposed in each of the plurality of sub-pixels (SP). The connection electrode CE is electrically connected to the second capacitor electrode ST2 and the second source electrode SE2 of the second transistor TR2 through a contact hole formed in the second passivation layer 115. The connection electrode (CE) is an electrode for electrically connecting the light emitting device (LED) and the second transistor (TR2), which is a driving transistor, and includes a first connection layer (CE1) and a second connection layer (CE2). For example, the first connection layer CE1 may be formed of the same material on the same layer as the first conductive layer 121a of the first assembly wiring 121, and the second connection layer CE2 may be formed of the same material as the first clad layer 121b.

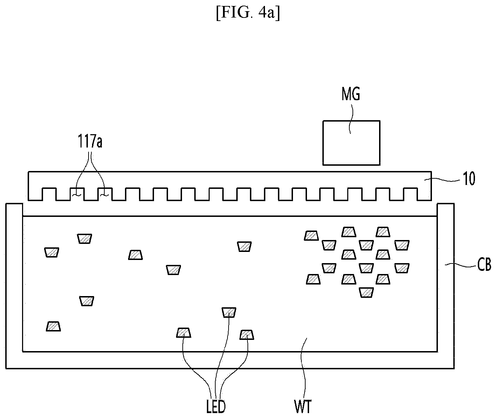

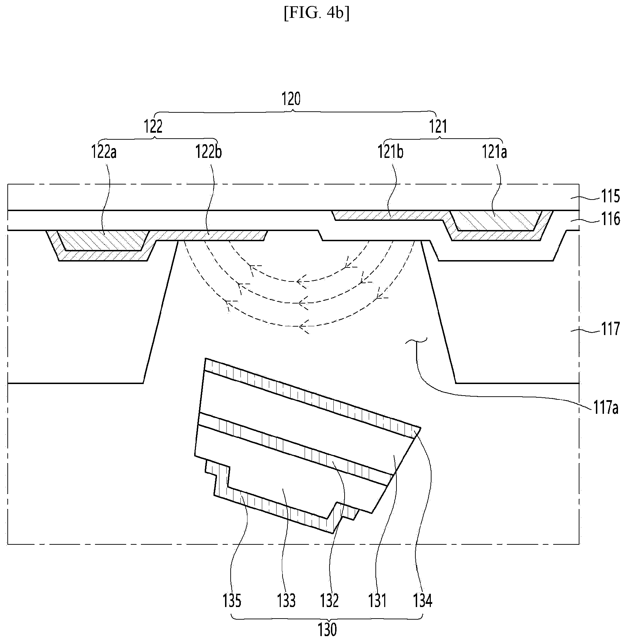

Next, the third passivation layer 116 may be disposed on the second layer (VDD2), the first assembly wiring 121, and the connection electrode (CE). The third passivation layer 116 is an insulating layer to protect the structure below the third passivation layer 116, and may be composed of a single layer or multiple layers of silicon oxide (SiOx) or silicon nitride (SiNx), but is not limited thereto. In addition, the third passivation layer 116 may function as an insulating layer to prevent short circuit defects due to migration between the first assembly wiring 121 and the second assembly wiring 122 when manufacturing the display device 100, and this will be described later with reference to FIGS. 4A and 4B.

A plurality of second assembly wiring lines 122 among the plurality of assembly wiring lines 120 are disposed on the third passivation layer 116. Each of the plurality of second assembly wirings 122 is disposed in a plurality of sub-pixels (SP) arranged on the same line as described above, and the plurality of first assembly wirings 121 and the plurality of second assembly wirings 122 may be placed spaced apart from each other.

Each of the plurality of second assembly wirings 122 may include a second conductive layer 122a and a second clad layer 122b. The second conductive layer 122a may be disposed on the third passivation layer 116. And the second clad layer 122b may be electrically connected to the second conductive layer 122a. For example, the second clad layer 122b may be disposed to cover the top and side surfaces of the second conductive layer 122a. And the second conductive layer 122a may have a thickness greater than that of the second clad layer 122b.

The second clad layer 122b, like the first clad layer 121b, is also made of a material that is more resistant to corrosion than the second conductive layer 122a, when manufacturing the display device 100, short-circuit defects due to migration between the first assembly wiring 121 and the second assembly wiring 122 may be minimized. For example, the second clad layer 122b may be made of molybdenum (Mo), molybdenum titanium (MoTi), etc., but is not limited thereto.

As mentioned above, the second clad layer 122b and the first clad layer 121b may be arranged to be spaced apart from each other without overlapping. However, if the distance between the first clad layer 121b and the second clad layer 121b is too far, the assembly rate of the light emitting device 130 decreases, so the assembly rate of the light emitting device 130 may be improved by placing them as close as possible. When the separation distance between the first clad layer 121b and the second clad layer 122b is MD, the separation distance MD inevitably includes a process margin, when the first clad layer 121b and the second clad layer 122b are formed as heterogeneous layers, there is a limit to precisely controlling the separation distance (MD) between the first clad layer 121b and the second clad layer 122b.

Next, the second planarization layer 117 may be disposed on the plurality of second assembly wirings 122. The second planarization layer 117 may be composed of a single layer or a double layer, and may be made of, for example, an acryl-based organic material, but is not limited thereto.

Meanwhile, the second planarization layer 117 has a plurality of first openings 117a on which each of the plurality of light emitting devices (LED) is seated, and a plurality of second openings 117b exposing each of the plurality of connection electrodes (CE).

A plurality of first openings 117a may be disposed in each sub-pixel SP. At this time, more than one first opening 117a may be disposed in one sub-pixel SP. For example, one first opening 117a or two first openings 117a may be disposed in one sub-pixel SP.

The plurality of first openings 117a are parts into which a plurality of light emitting devices (LEDs) are inserted, and may also be referred to as pockets. The plurality of first openings 117a may be formed to overlap the plurality of assembly wirings 120. For example, one first opening 117a may overlap the first assembly wiring 121 and the second assembly wiring 122 arranged adjacent to each other in one sub-pixel SP.

Additionally, a portion of the second clad layer 122b of the plurality of second assembly wirings 122 may be exposed through the first opening 117a. On the other hand, because the third passivation layer 116 covers all of the first assembly wiring 121 in the first opening 117a, the first assembly wiring 121 overlaps the first opening 117a, but may not be exposed from the first opening 117a.

For example, the diameter (CD) of the light emitting device is 60% to 80% of the diameter (PD) of the pocket, in the case of heterogeneous assembly wiring, the separation distance (MD) of the assembly wiring accounts for 50% to 75% of the pocket diameter (PD). Accordingly, when the light emitting device 130 is disposed in the pocket with a bias toward the first assembly wiring 121, it may be difficult for the light emitting device 130 to make contact with the second assembly wiring 122. Also, the process margin for forming the assembly wiring 120 is constant regardless of the size of the light emitting device 130. Therefore, as the size of the light emitting device 130, that is, the diameter (CD) of the light emitting device becomes smaller, contact with the assembly wiring 120 due to bias of the light emitting device 130 may become more difficult. The structure to solve this will be explained later.

Subsequently, a plurality of second openings 117b may be disposed in a plurality of sub-pixels SP. The plurality of second openings 117b are portions that expose the connection electrodes CE of each of the plurality of sub-pixels SP. The connection electrode (CE) under the second planarization layer 117 is exposed through the plurality of second openings 117b and may be electrically connected to the light emitting device (LED), and may transmit the driving current from the second transistor TR2 to the light emitting device (LED). In this case, the third passivation layer 116 may have a contact hole in the area overlapping the second opening 117b, and the connection electrode CE may be exposed from the second planarization layer 117 and the third passivation layer 116.

A plurality of light emitting devices (LEDs) may be disposed in the plurality of first openings 117a. The plurality of light emitting devices (LEDs) are light emitting devices (LEDs) that emit light by electric current. The plurality of light emitting devices (LEDs) may include light emitting devices (LEDs) that emit red light, green light, blue light, etc., and a combination of these may produce light of various colors, including white. For example, the light emitting device (LED) may be a light emitting diode (LED) or a micro LED, but is not limited thereto. In this case, micro LED may mean a light emitting device with a size of 100*µ*m or less or a structure that does not include a wafer substrate for growing the LED below the LED.

Hereinafter, the description will be made assuming that the plurality of light emitting devices (LEDs) include a red light emitting device 130 disposed in the red sub-pixel (SPR), a green light emitting device 140 disposed in the green sub-pixel (SPG), and a blue light emitting device 150 disposed in the blue sub-pixel (SPB). However, the plurality of light emitting devices (LEDs) are composed of light emitting devices (LEDs) that emit light of the same color, and may display images of various colors by using a separate light conversion member that converts light from a plurality of light emitting devices (LEDs) into light of different colors, but is not limited thereto.

The plurality of light emitting devices (LEDs) may include a red light emitting device 130 disposed in the red sub-pixel (SPR), a green light emitting device 140 disposed in the green sub-pixel (SPG), and a blue light emitting device 150 disposed in a blue sub-pixel (SPB).

Referring to FIG. 3, the second semiconductor layer 133 may be disposed on the first semiconductor layer 131 in the red light emitting device 130 disposed in the red sub-pixel (SPR). The first semiconductor layer 131 and the second semiconductor layer 133 may be layers formed by doping n-type and p-type impurities into a specific material. For example, the first semiconductor layer 131 and the second semiconductor layer 133 may include an AlInGaP-based semiconductor layer, for example, the first semiconductor layer 131 and the second semiconductor layer 133 may be a layer doped with a p-type or n-type impurity in a material such as indium aluminum phosphide (InAlP) or gallium arsenide (GaAs). The p-type impurity may be magnesium (Mg), zinc (Zn), beryllium (Be), etc., and the n-type impurity may be silicon (Si), germanium (Ge), tin (Sn), etc., but are not limited thereto.

The light emitting layer 132 that emits red light may be disposed between the first semiconductor layer 131 and the second semiconductor layer 133. The light emitting layer 132 may emit light by receiving holes and electrons from the first semiconductor layer 131 and the second semiconductor layer 133. The light emitting layer 132 may have a single-layer or multi-quantum well (MQW) structure.

The light emitting layer 132 may convert injected electrical energy into light with a specific wavelength within the range of about 570 nm to about 630 nm. The change in specific wavelength is determined by the size of the band gap of the light emitting diode, which may be adjusted by changing the composition ratio of Al and Ga.

For example, as the composition ratio of Al increases, the wavelength becomes shorter.

The first electrode 134 may be disposed on the lower surface of the first semiconductor layer 131, and the second electrode 135 may be disposed on the upper surface of the second semiconductor layer 133. The first electrode 134 is an electrode bonded to the second assembly wiring 122 exposed through the first opening 117a, the second electrode 135 is an electrode that electrically connects the second semiconductor layer 133 to a pixel electrode (PE), which will be described later. The first electrode 134 and the second electrode 135 may be formed of a conductive material.

In this case, in order to bond the first electrode 134 to the second assembly wiring 122, the first electrode 134 may be made of a eutectic metal. For example, the first electrode 134 is made of tin (Sn), indium (In), zinc (Zn), lead (Pb), nickel (Ni), gold (Au), platinum (Pt), and copper (Cu), etc., but is not limited to this.

And both the green light emitting device 140 and the blue light emitting device 150 may be formed with the same or similar structure as the red light emitting device 130. For example, the green light emitting device 140 may include a first electrode, a first semiconductor layer on the first electrode, a green light emitting layer on the first semiconductor layer, a second semiconductor layer on the green light emitting layer, and a second electrode on the second semiconductor layer, and the blue light emitting device may also include a structure in which a first electrode, a first semiconductor layer, a blue light emitting layer, a second semiconductor layer, and a second electrode are sequentially stacked.

However, the green light emitting device 140 and the blue light emitting device 150 may be formed of a compound selected from the group consisting of GaN, AlGaN, InGaN, AlInGaN, GaP, AlN, GaAs, AlGaAs, InP, and mixtures thereof, but it is not limited to this.

Meanwhile, although not shown in the drawing, an insulating layer surrounding a portion of each of the plurality of light emitting devices (LEDs) may be disposed. Specifically, the insulating layer may cover at least one side of the light emitting device (LED) among the outer surfaces of the plurality of light emitting devices (LED). An insulating layer is formed on the light emitting device (LED) to protect the light emitting device (LED), and when forming the first electrode 134 and the second electrode 135, electrical short circuit of the first semiconductor layer 131 and the second semiconductor layer 133 may be prevented.

Next, the third planarization layer 118 may be disposed on the plurality of light emitting devices (LEDs). The third planarization layer 118 may planarize the upper part of the substrate 110 on which a plurality of light emitting devices (LEDs) are disposed, and a plurality of light emitting devices (LEDs) may be stably fixed in the first opening 117a by the third planarization layer 118. The third planarization layer 118 may be composed of a single layer or a double layer, and may be made of, for example, an acryl-based organic material, but is not limited thereto.

The pixel electrode (PE) may be disposed on the third planarization layer 118. The pixel electrode (PE) is an electrode for electrically connecting a plurality of light emitting devices (LED) and the connection electrode (CE). The pixel electrode (PE) may be electrically connected to the light emitting device (LED) of the first opening (117a) and the connection electrode (CE) of the second opening (117b) through a contact hole formed in the third planarization layer (118). Accordingly, the second electrode 135 of the light emitting device (LED), the connection electrode (CE), and the second transistor (TR2) may be electrically connected through the pixel electrode (PE).

The third layer (VDD3) of the high-potential power supply line (VDD) is disposed on the third planarization layer 118. The third layer (VDD3) may electrically connect the first layer (VDD1) and the second layer (VDD2) arranged in different rows. For example, the third layer (VDD3) extends in the row direction between the plurality of sub-pixels (SP), and may electrically connect the plurality of second layers (VDD2) of the high-potential power supply line (VDD) extending in the column direction to each other. In addition, as the plurality of high-potential power supply lines (VDD) are connected in a mesh form through the third layer (VDD3), there is a technical effect of reducing the voltage drop phenomenon.

A black matrix (BM) may be disposed on the third planarization layer 118. The black matrix BM may be disposed between the plurality of sub-pixels SP on the third planarization layer 118. The black matrix (BM) may prevent color mixing between the plurality of sub-pixels (SP). The black matrix (BM) may be made of an opaque material, for example, black resin, but is not limited thereto.

The protective layer 119 may be disposed on the pixel electrode (PE), the third planarization layer 118, and the black matrix (BM). The protective layer 119 is a layer to protect the structure below the protective layer 119, and may be composed of a single layer or multiple layers of translucent epoxy, silicon oxide (SiOx), or silicon nitride (SiNx), but is not limited thereto.

Meanwhile, in the first opening 117a, the plurality of first assembly wirings 121 are spaced apart from the plurality of light emitting devices (LED), and only the plurality of second assembly wirings 122 may contact the plurality of light emitting devices (LEDs). This is to prevent defects that occur when a plurality of light emitting devices (LEDs) come into contact with both the first assembly wiring 121 and the plurality of second assembly wiring 122 during the manufacturing process of the display device 100, the third passivation layer 116 may be formed on the plurality of first assembly wirings 121, and the plurality of light emitting devices (LEDs) may be contacted only to the plurality of second assembly wirings 122. Hereinafter, a method of manufacturing the display device 100 according to an embodiment of the present invention will be described in detail with reference to FIGS. 4A to 4C.

Meanwhile, the plurality of light emitting devices 130 may be self-assembled inside the first opening 117a by the plurality of assembly wirings 120. Hereinafter, the self-assembly process of the plurality of light emitting devices 130 will be described with reference to FIGS. 4A to 4C.

FIGS. 4A to 4C are process diagrams for explaining a method of manufacturing a display device according to an embodiment. FIGS. 4A to 4C are process diagrams for explaining a process of self-assembling a plurality of light emitting devices 130 into the first opening 117a.

Referring to FIG. 4A, the light emitting device 130 is introduced into the chamber CB filled with the fluid WT. The fluid WT may include water, etc., and the chamber CB filled with the fluid WT may have an open top.

Next, the mother substrate 10 may be placed on the chamber CB filled with the light emitting device 130. The mother substrate 10 is a substrate composed of a plurality of substrates 110 forming the display device 100, when self-assembling the plurality of light emitting devices 130, the mother substrate 10 on which the plurality of assembly wirings 120 and the second planarization layer 117 are formed may be used.

And the mother substrate 10 formed with the first assembly wiring 121, the second assembly wiring 122, and the second planarization layer 117 is placed on the chamber CB or inserted into the chamber CB. At this time, the mother substrate 10 may be positioned so that the first opening 117a of the second planarization layer 117 and the fluid WT face each other.

Next, the magnet MG may be placed on the mother substrate 10. The light emitting devices 130 that sink or float on the bottom of the chamber CB may move toward the mother substrate 10 by the magnetic force of the magnet MG.

At this time, the light emitting device 130 may include a magnetic material to move by a magnetic field. For example, the light emitting device 130 may include a ferromagnetic material such as iron, cobalt, or nickel.

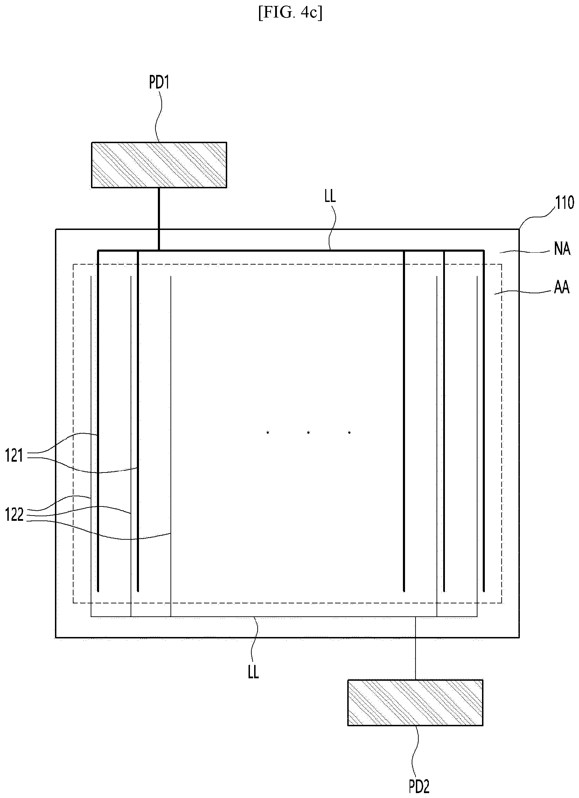

Next, referring to FIGS. 4B and 4C, the light emitting device 130 moved toward the second planarization layer 117 by the magnet MG may be self-assembled in the first opening 117a by the electric field formed by the first assembly wiring 121 and the second assembly wiring 122.

An alternating voltage may be applied to the plurality of first assembly wirings 121 and the plurality of second assembly wirings 122 to generate an electric field. The light emitting device 130 may be dielectrically polarized by this electric field to have polarity. And the dielectrically polarized light emitting device 130 may be moved or fixed in a specific direction by dielectrophoresis (DEP), that is, an electric field. Accordingly, the plurality of light emitting devices 130 may be fixed within the first opening 117a of the second planarization layer 117 using dielectrophoresis.

At this time, the same voltage is applied to the plurality of first assembly wirings 121 and the plurality of second assembly wirings 122 when driving the display device 100, but different voltages are applied when manufacturing the display device 100. To this end, when manufacturing the display device 100, the plurality of first assembly wirings 121 and the plurality of second assembly wirings 122 may be connected to different assembly pads and different voltages may be applied.

In relation to this, referring to FIG. 4C, when manufacturing the display device 100 and self-assembling the plurality of light emitting devices 130, the plurality of assembly wirings 120 may be connected to the assembly pad. Specifically, on the mother substrate 10, a plurality of substrates 110 forming the display device 100, a plurality of assembly pads, and a plurality of connection portions for the assembly wiring 120 are disposed.

The plurality of assembly pads are pads for applying voltage to the plurality of assembly wirings 120, and may be electrically connected to a plurality of assembly wirings 120 disposed on each of the plurality of substrates 110 forming the mother substrate 10. A plurality of assembly pads may be formed on the mother substrate 10 outside the substrate 110 of the display device 100, and when the manufacturing process of the display device 100 is completed, the substrate 110 of the display device 100 and may be separated. For example, voltage is applied to the plurality of first assembly wirings 121 through the first assembly pad PD1, and voltage is applied to the plurality of second assembly wirings 122 through the second assembly pad PD2, so that an electric field may be formed to align the plurality of light emitting devices 130.

At this time, the plurality of first assembly wirings 121 arranged on one substrate 110 are connected to one using the link wiring LL, the plurality of second assembly wirings 122 may also be connected into one, so that each of the plurality of first assembly wirings 121 and the plurality of second assembly wirings 122 may be easily connected to the assembly pad.

For example, the plurality of first assembly wirings 121 may be connected to one through the link wiring LL, and the plurality of second assembly wirings 122 may also be connected to one through the link wiring LL. In this case, each of the plurality of first assembly wirings 121 and the plurality of second assembly wirings 122 disposed on one substrate 110 is not individually connected to the assembly pad, but a plurality of first assembly wirings 121 and a link wire (LL) connecting each of the plurality of second assembly wirings 122 into one and the assembly pad are electrically connected, a voltage for self-assembly of the light emitting device 130 may be easily applied to the plurality of first assembly wirings 121 and the plurality of second assembly wirings 122.

Therefore, after placing the mother substrate 10 in the chamber (CB) into which the plurality of light emitting devices 130 are inserted, an electric field may be formed by applying an alternating voltage to a plurality of assembly wirings 120 through a plurality of assembly pads, and a plurality of light emitting devices 130 may be easily self-assembled into the first opening 117a of the second planarization layer 117.

Next, the mother substrate 10 may be flipped 180° while the light emitting device 130 is fixed in the first opening 117a using the electric fields of the plurality of first assembly wirings 121 and the plurality of second assembly wirings 122. In the embodiment, the mother substrate 10 may be turned over while voltage is applied to the plurality of first assembly wirings 121 and the plurality of second assembly wirings 122 and a subsequent process may be performed.

After the self-assembly process of the plurality of light emitting devices 130 is completed, the mother substrate 10 may be cut along the scribing line and separated into a plurality of substrates 110. The same voltage may be easily applied to the plurality of first assembly wirings 121 and the plurality of second assembly wirings 122 through the link wire LL connecting the plurality of first assembly wirings 121 into one and the link wire LL connecting the plurality of second assembly wirings 122 into one. For example, when driving the display device 100, by connecting the link wire LL that connects each of the plurality of first assembly wirings 121 and the plurality of second assembly wirings 122 into one and the driving IC, voltage may be applied to the plurality of first assembly wirings 121 and the plurality of second assembly wirings 122.

In the display device 100 and its manufacturing method according to an embodiment of the present invention, at least some of the plurality of assembly wirings 120 for self-assembly of the plurality of light emitting devices 130 may be used as wiring for applying a low-potential power supply voltage to the plurality of light emitting devices 130. When manufacturing the display device 100, a plurality of light emitting devices 130 floating in the fluid WT may be moved adjacent to the mother substrate 10 using a magnetic field. Next, different voltages may be applied to the plurality of first assembly wirings 121 and the plurality of second assembly wirings 122 to form an electric field, the plurality of light emitting devices 130 may be self-assembled within the plurality of first openings 117a by an electric field. At this time, when driving the display device 100 by separately forming a wiring that supplies a low-potential voltage and electrically connecting it to the first semiconductor layer 134 of the plurality of self-assembled light emitting devices 130, a plurality of assembly wirings 120 may be used as wiring for supplying low-potential voltage to a plurality of light emitting devices 130. Therefore, in the display device 100 according to an embodiment of the present invention, the plurality of assembly wirings 120 may be used not only for self-assembly of the plurality of light emitting devices 130 but also as wiring for driving the plurality of light emitting devices 130.

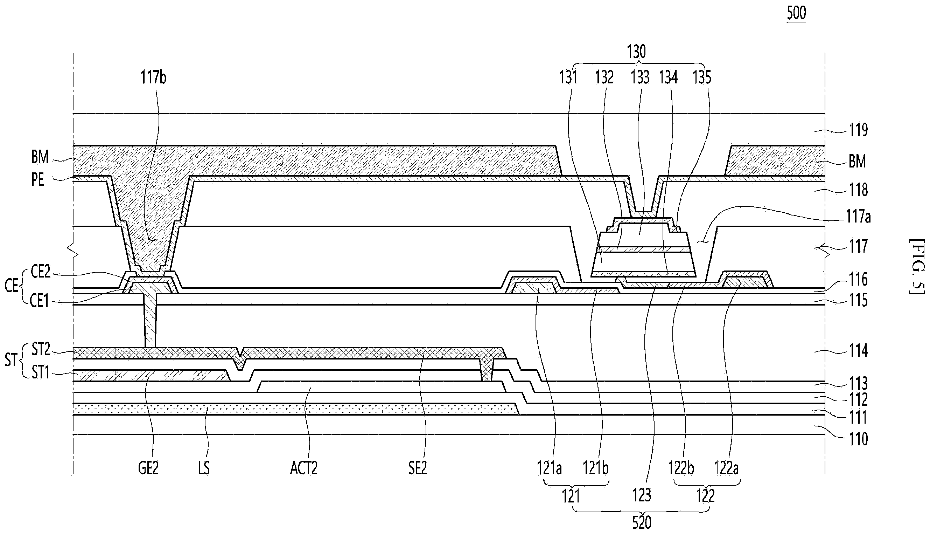

FIG. 5 is a cross-sectional view of a display device according to a second embodiment. The description of the second embodiment of FIG. 5 will focus on the differences in assembly wiring from the first embodiment of FIG. 3.

Referring to FIG. 5, a plurality of assembly wirings 520 generate an electric field to align a plurality of light emitting devices (LEDs) when manufacturing the display device 500, and is a wiring that supplies a low-potential power voltage to a plurality of light emitting devices (LEDs) when the display device 500 is driven. Accordingly, the assembly wiring 520 may be referred to as a low-potential power wiring. The plurality of assembly wirings 520 may be arranged in a column direction along the plurality of sub-pixels SP arranged on the same line. The plurality of assembly wirings 520 may be arranged to overlap the plurality of sub-pixels SP arranged in the same column. For example, one first assembly wiring 121 and a second assembly wiring 122 are disposed in a red sub-pixel (SPR) arranged in the same column, one first assembly wiring 121 and a second assembly wiring 122 are disposed in the green sub-pixel (SPG), and one first assembly wiring 121 and a second assembly wiring 122 are disposed in the blue sub-pixel (SPG).

The plurality of assembly wiring lines 520 may include a plurality of first assembly wiring lines 121 and a plurality of second assembly wiring lines 122. When the display device 500 is driven, the same low-potential voltage may be applied as alternating current to the plurality of first assembly wirings 121 and the plurality of second assembly wirings 122. The plurality of first assembly wirings 121 and the plurality of second assembly wirings 122 may be alternately arranged. And in each of the plurality of sub-pixels SP, one first assembly wiring 121 and one second assembly wiring 122 are disposed adjacent to each other.

The plurality of first assembly wirings 121 and the plurality of second assembly wirings 122 may be made of a conductive material, for example, copper (Cu) and chromium (Cr), but are not limited thereto.

The plurality of first assembly wirings 121 may include a first conductive layer 121a and a first clad layer 121b. The first conductive layer 121a may be disposed on the second passivation layer 115. The first clad layer 121b is in contact with the first conductive layer 121a and is electrically connected. For example, the first clad layer 121b may be disposed to cover the top and side surfaces of the first conductive layer 121a. Additionally, the first conductive layer 121a may have a thickness greater than that of the first clad layer 121b.

Subsequently, the third passivation layer 116 may be disposed on the first assembly wiring 121. The third passivation layer 116 is an insulating layer to protect the structure below the third passivation layer 116, and may be composed of a single layer or multiple layers of silicon oxide (SiOx) or silicon nitride (SiNx), but is not limited thereto. Additionally, the third passivation layer 116 may function as an insulating layer to prevent short circuit defects due to migration between the first assembly wiring 121 and the second assembly wiring 122 when manufacturing the display device 500.

Among the plurality of assembly wiring lines 120, a plurality of second assembly wiring lines 122 may be disposed on the third passivation layer 116. Each of the plurality of second assembly wirings 122 is disposed in a plurality of sub-pixels (SP) arranged on the same line as described above, and the plurality of first assembly wirings 121 and the plurality of second assembly wirings 122 may be arranged to overlap each other.

Each of the plurality of second assembly wirings 122 includes a second conductive layer 122a and a second clad layer 122b. The second conductive layer 122a may be disposed on the third passivation layer 116. And the second clad layer 122b is in contact with the second conductive layer 122a and is electrically connected. For example, the second clad layer 122b may be disposed to cover the top and side surfaces of the second conductive layer 122a. And the second conductive layer 122a may have a thickness greater than that of the second clad layer 122b.

As the second clad layer 122b is made of a material that is more resistant to corrosion than the second conductive layer 122a, when manufacturing the display device 500, short-circuit defects due to migration between the first assembly wiring 121 and the second assembly wiring 122 may be minimized. For example, the second clad layer 122b may be made of molybdenum (Mo), molybdenum titanium (MoTi), etc., but is not limited thereto.

As mentioned above, if the first clad layer 121b and the second clad layer 122b overlap each other or the distance between them is too long, the assembly rate of the light emitting device 130 decreases. Accordingly, the assembly rate of the light emitting device 130 may be improved by arranging the first clad layer 121b and the second clad layer 122b as close as possible without overlapping. However, since the separation distance between the first clad layer 121b and the second clad layer 122b are to be determined by considering the process margin, there is a limit to precisely controlling the separation distance. Accordingly, in the display device 500 according to the second embodiment, by arranging the third clad layer 123 between the first clad layer 121b and the second clad layer 122b to contact the second clad layer 122b, there is a technical effect of precisely controlling the separation distance between the first clad layer 121b and the second clad layer 122b and improving the assembly rate of the light emitting device 130.

In this case, the third clad layer 123 may be included in the second assembly wiring 122, and the third clad layer 123 may be arranged in parallel with the second clad layer 122b. Additionally, the separation distance between the third clad layer 123 and the second clad layer 122b may be adjusted to be zero or very small. In some cases, the edge portion of the third clad layer 123 may be disposed over the second clad layer 121b.

The third clad layer 123 is made of a transparent conductive material. For example, it may be made of ITO (Indium Tin Oxide), MgO (Magnesium Oxide), ZnO (Zinc Oxide), SnO2 (Stannum Oxide), etc., but is not limited thereto. The manufacturing method of the assembly wiring 520 will be described later.

The second planarization layer 117 including the first opening 117a is disposed on the assembly wiring 520 and the light emitting element 130 is disposed within the first opening 117a, in the drawing, the light emitting element 130 is shown as contacting only the third clad layer 123, but specifically, the light emitting device 130 may be slightly tilted in the direction of the second clad layer 122b and may come into contact with the second clad layer 122b. Since the size of the light emitting device 130 is relatively large compared to the assembly wiring 520, the degree of tilt of the light emitting device 130 is very small and may not affect the assembly rate of the light emitting device 130.

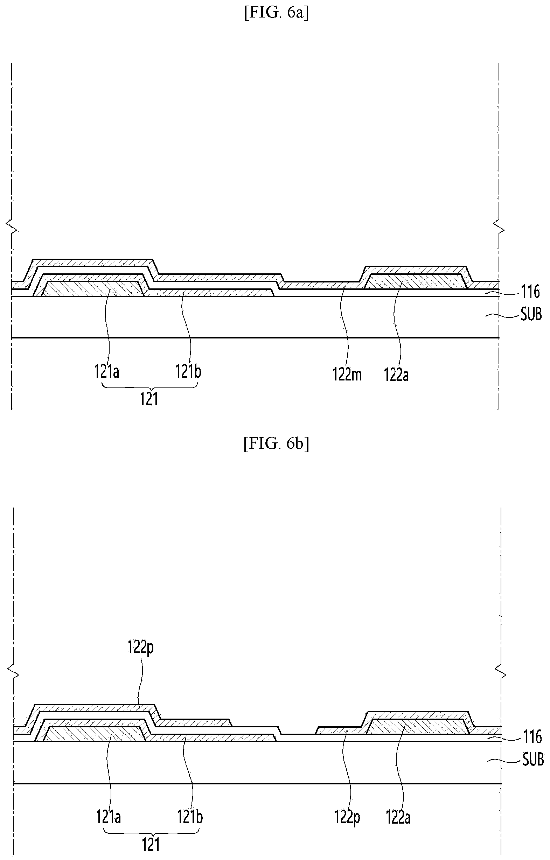

FIGS. 6A to 6H are process charts for explaining the manufacturing method of the display device according to the second embodiment. A method of manufacturing the assembly wiring 520 will be described based on the display device 500 of FIG. 5.

Referring to FIG. 6A, the second passivation layer 115 from the substrate 110 of FIG. 5 is briefly referred to as a TFT substrate (SUB). The first conductive layer 121a is formed on the TFT substrate (SUB). The first conductive layer 121a is formed of a conductive material through a deposition and patterning process. The deposition and patterning process includes deposition, photo resist coating, exposure, develop, etch, and photo resist strip.

Next, the first clad layer 121b is deposited to cover the top and side surfaces of the first conductive layer 121a, and a patterning process is performed. A third passivation layer 116 is formed on the entire surface of the TFT substrate (SUB) on the first clad layer 121b, and a second conductive layer 122a is formed on the third passivation layer 116 through a deposition and patterning process to be spaced apart from the first conductive layer 121a and the first clad layer 121b.

Next, a second clad material layer 122m is deposited to cover the top and side surfaces of the second conductive layer 122a. FIG. 6a shows the step of depositing the second clad material layer 122m, a step before the patterning process.

FIG. 6b shows the patterning process step of the second clad material layer 122m, the second clad material layer 122m in a partial area between the second conductive layer 122a and the first conductive layer 121a is removed. The second clad patterning layer 122p is formed through a patterning process of the second clad material layer 122m.

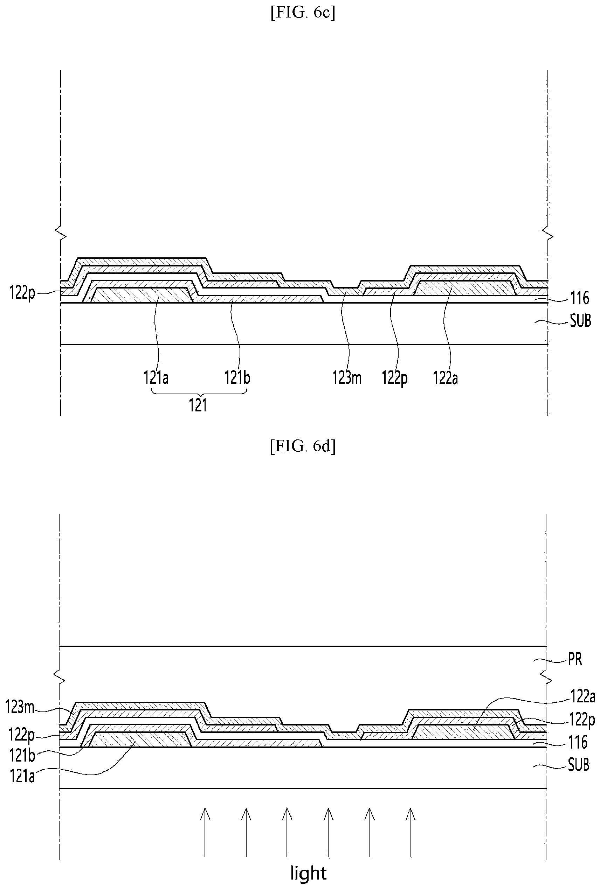

FIG. 6c shows the step of depositing the third clad material layer 123m, and the third clad material layer 123m is formed on the entire surface of the TFT substrate (SUB) on the second clad patterning layer 122p.

FIG. 6c shows the step of depositing the third clad material layer 123m, and the third clad material layer 123m is formed on the entire surface of the TFT substrate (SUB) on the second clad patterning layer 122p.

FIG. 6d shows the step of applying photosensitive resin (PR) on the third clad material layer 123m and exposing it to light on the back of the TFT substrate (SUB). Light incident from the back of the TFT substrate (SUB) does not pass through the first assembly electrode 121, which functions as a mask, the second conductive layer 122a, and the second clad patterning layer 122p, but passes through the transparent third clad material layer 123m, the photosensitive resin PR disposed between the first clad layer 121b and the second clad patterning layer 122p covering the second conductive layer 122a is exposed to light. In this case, the photosensitive resin (PR) may be a negative PR that leaves an area exposed to light during development.

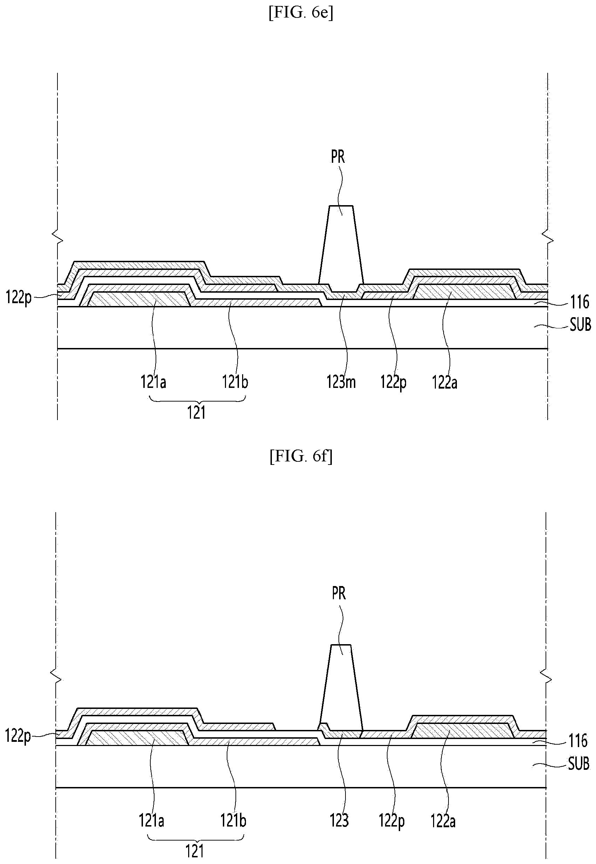

FIG. 6e shows the development stage, where the photosensitive resin (PR) is removed by washing the area exposed to light while the remaining area is washed with a developer.

FIG. 6F is an etching step, and a third class material layer 123m that does not overlapp with the photosensitive resin (PR) is etched and removed. After the etching process, the third class layer 123 is formed on the third passivation layer 116.

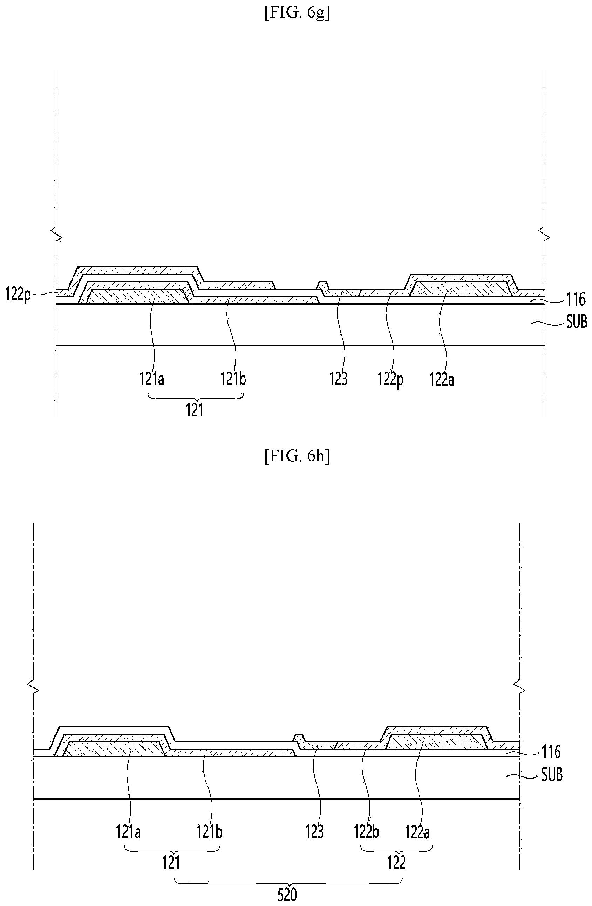

FIG. 6g shows the PR peeling step, in which the photosensitive resin (PR) remaining on the third clad layer 123 is removed.

FIG. 6h shows the step of removing part of the second clad patterning layer 122p. The second clad patterning layer 122p covers the top and side surfaces of the second conductive layer 122a, and the remaining portions except for the portion disposed in contact with the third clad layer 123 are removed using a separate mask. The removed and remaining second clad patterning layer 122p becomes the second clad layer 122b.

According to the manufacturing method of the display device according to the second embodiment, the third clad layer 123 is formed parallel to the second clad layer 122b, contacts the side of the second clad layer 122b, and is electrically connected. Additionally, the third clad layer 123 is adjacent to the first clad layer 121b without overlapping, and the separation distance in the row direction may be adjusted to be zero or very small.

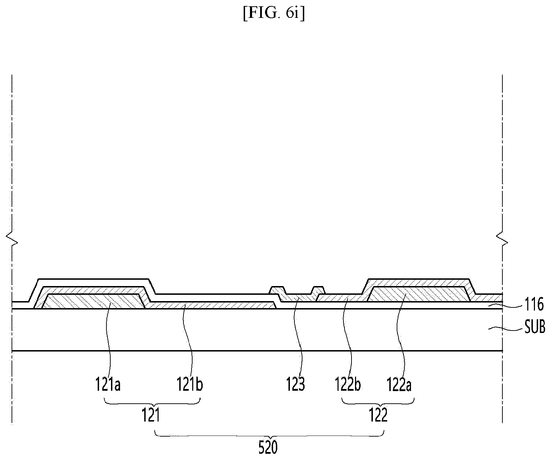

FIG. 6i is a modified example of the assembly wiring of the display device according to the second embodiment. Referring to FIG. 6D, in the process of patterning the photosensitive resin (PR) to pattern the third clad material layer 123m, the photosensitive resin (PR) may be left on the third clad material layer 123m with a larger area than the photosensitive resin (PR) in FIG. 6E by controlling the exposure amount during exposure on the back of the TFT substrate (SUB).

Afterwards, the third clad layer 123 may be formed as shown in FIG. 6I through an etching and PR peeling process of the third clad material layer 123m. In this case, the edge portion of the third clad layer 123 may be formed to span the first clad layer 121b and the second clad layer 122b. It is difficult to say that the third clad layer 123 overlaps the first clad layer 121b and the second clad layer 122b, so it may not affect the assembly rate of the light emitting device 130. However, the third clad layer 123 may be more securely electrically connected to the second clad layer 122b.

According to the manufacturing method of the display device according to the second embodiment, by forming a transparent third clad layer 123 connected to the second clad layer 122b between the first assembly wiring 121 and the second assembly wiring 122 using back exposure, there is a technical effect of improving the assembly rate of the light emitting device 130 by precisely adjusting the spacing between assembly wirings for assembling the light emitting device 130.

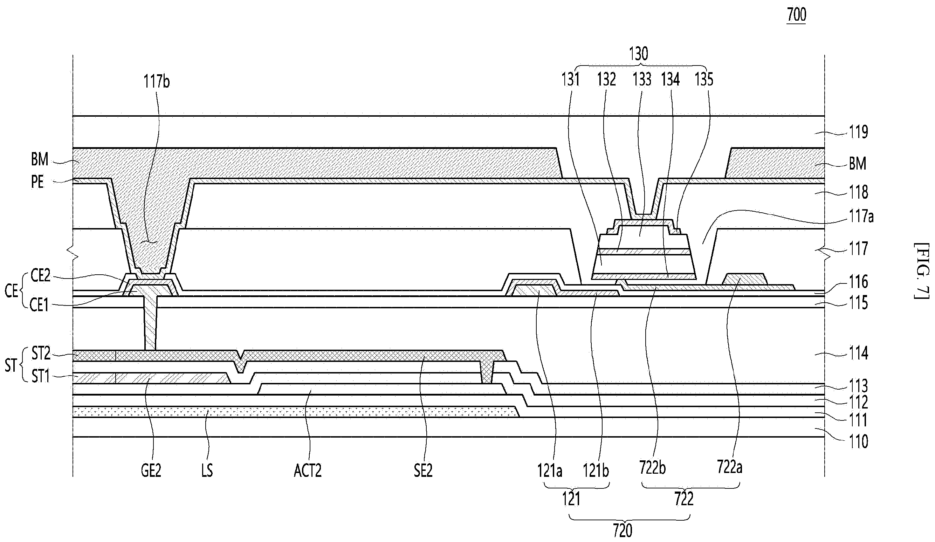

FIG. 7 is a cross-sectional view of a display device according to a third embodiment. Since FIG. 7 differs from FIG. 5 only in the arrangement and structure of the assembly wiring and the remaining components are applied the same, description of overlapping components will be omitted.

Referring to FIG. 7, the plurality of assembly wirings 720 generate an electric field for aligning the plurality of light emitting elements (LEDs) when manufacturing the display device 700, and the plurality of assembly wirings 720 are a wiring that supplies low-potential power voltage to a plurality of light emitting elements (LEDs) when the display device 700 is driven. Accordingly, the assembly wiring 720 may be referred to as a low-potential power wiring. The plurality of assembly wirings 720 may be arranged in a column direction along the plurality of sub-pixels SP arranged on the same line. The plurality of assembly wiring 720 may be arranged to overlap the plurality of sub-pixels SP arranged in the same column. For example, one first assembly wiring 121 and a second assembly wiring 722 are disposed in a red sub-pixel (SPR) arranged in the same row, one first assembly wiring 121 and a second assembly wiring 722 are disposed in the green sub-pixel (SPG), and one first assembly wiring 121 and a second assembly wiring 722 are disposed in the blue sub-pixel (SPB).

The plurality of assembly wiring lines 720 includes a plurality of first assembly wiring lines 121 and a plurality of second assembly wiring lines 722. When the display device 700 is driven, the same low-potential voltage may be applied as alternating current to the plurality of first assembly wirings 121 and the plurality of second assembly wirings 722. The plurality of first assembly wirings 121 and the plurality of second assembly wirings 722 may be alternately arranged. And in each of the plurality of sub-pixels SP, one first assembly wiring 121 and one second assembly wiring 722 are disposed adjacent to each other.

The plurality of first assembly wirings 121 and the plurality of second assembly wirings 722 may be made of a conductive material, for example, copper (Cu) and chromium (Cr), but are not limited thereto.

The plurality of first assembly wirings 121 include a first conductive layer 121a and a first clad layer 121b. The first conductive layer 121a may be disposed on the second passivation layer 115. The first clad layer 121b is in contact with the first conductive layer 121a and is electrically connected. For example, the first clad layer 121b may be disposed to cover the top and side surfaces of the first conductive layer 121a. Additionally, the first conductive layer 121a may have a thickness greater than that of the first clad layer 121b.

Subsequently, the third passivation layer 116 may be disposed on the first assembly wiring 121. The third passivation layer 116 is an insulating layer to protect the structure below the third passivation layer 116, and may be composed of a single layer or multiple layers of silicon oxide (SiOx) or silicon nitride (SiNx), but is not limited thereto. In addition, when manufacturing the display device 700, the third passivation layer 116 has the technical effect of functioning as an insulating layer to prevent short circuit defects due to migration between the first assembly wiring 121 and the second assembly wiring 722.

Among the plurality of assembly wiring lines 720, a plurality of second assembly wiring lines 722 may be disposed on the third passivation layer 116. Each of the plurality of second assembly wirings 722 is disposed in a plurality of sub-pixels (SP) arranged on the same line as described above, and the plurality of first assembly wirings 121 and the plurality of second assembly wirings 722 may be arranged to overlap each other.

Each of the plurality of second assembly wirings 722 includes a second conductive layer 722a and a second clad layer 722b. The second clad layer 722b is disposed on the third passivation layer 116. And the second conductive layer 722a is in contact with the second clad layer 122b and is electrically connected. For example, the second conductive layer 722a may be disposed on the second clad layer 722b. And the second conductive layer 722a may have a thickness greater than that of the second clad layer 722b.

The second clad layer 722b is made of a material that is more resistant to corrosion than the second conductive layer 722a, when manufacturing the display device 700, there is a technical effect of minimizing short circuit defects due to migration between the first assembly wiring 121 and the second assembly wiring 722. For example, the second clad layer 722b is made of a transparent conductive material. For example, it may be made of ITO (Indium Tin Oxide), MgO (Magnesium Oxide), ZnO (Zinc Oxide), SnO2 (Stannum Oxide), etc., but is not limited thereto.

As mentioned above, if the first clad layer 121b and the second clad layer 722b overlap each other or the distance between them is too long, the assembly rate of the light emitting device 130 decreases. Accordingly, the assembly rate of the light emitting device 130 may be improved by arranging the first clad layer 121b and the second clad layer 722b as close as possible without overlapping. However, since the separation distance between the first clad layer 121b and the second clad layer 722b may only be determined by considering the process margin, there is a limit to precisely controlling the separation distance. Accordingly, in the display device 700 according to the third embodiment, the separation distance from the first clad layer 121b may be adjusted to be zero or very small by arranging the second clad layer 722b with a transparent conductive material. In some cases, the edge portion of the second clad layer 722b may be disposed over the first clad layer 121b. A manufacturing method capable of precisely controlling the separation distance from the first assembly wiring 121 when forming the second assembly wiring 722 will be described later.

The second planarization layer 117 including the first opening 117a is disposed on the assembly wiring 720 and the light emitting device 130 is disposed within the first opening 117a, in the drawing, the light emitting element 130 is shown as contacting only the edge portion of the second clad layer 722b, but substantially, the light emitting device 130 is slightly tilted in the direction of the second clad layer 722b and comes into contact with the second clad layer 722b over a larger area. Since the size of the light emitting device 130 is relatively large compared to the assembly wiring 720, the degree of tilt of the light emitting device 130 is very small and does not affect the assembly rate of the light emitting device 130.

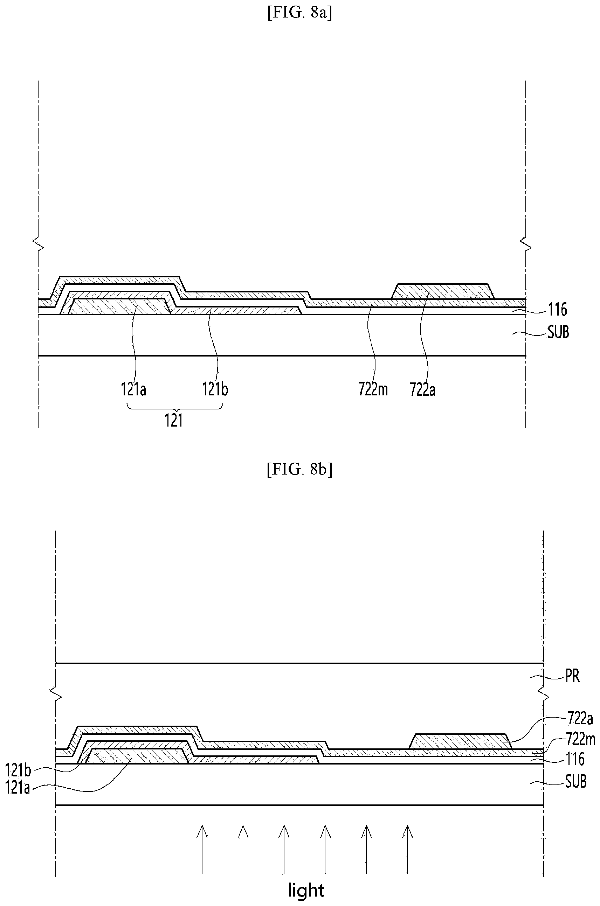

FIGS. 8A to 8E are process charts for explaining the manufacturing method of the display device according to the third embodiment. A method of manufacturing the assembly wiring 720 will be described based on the display device 700 of FIG. 7.

Referring to FIG. 8A, the second passivation layer 115 from the substrate 110 of FIG. 7 is briefly referred to as a TFT substrate (SUB). The first conductive layer 121a is formed on the TFT substrate (SUB). The first conductive layer 121a is formed of a conductive material through a deposition and patterning process.

Next, the first clad layer 121b is deposited to cover the top and side surfaces of the first conductive layer 121a, and a patterning process is performed. A third passivation layer 116 is formed on the entire surface of the TFT substrate (SUB) on the first clad layer 121b, and a second clad material layer 722m is formed on the third passivation layer 116 through a deposition process. The second clad material layer 722m is formed on the entire surface of the TFT substrate (SUB) on the third passivation layer 116.

Next, a second conductive layer 722a is formed on the upper surface of the second clad material layer 722m through a deposition and patterning process to be spaced apart from the first assembly wiring 121.

FIG. 8b shows the patterning process step of the second clad material layer 722m, specifically, this is the step of applying photosensitive resin (PR) on the second clad material layer 722m and the second conductive layer 722a and exposing it to light on the back side of the TFT substrate (SUB). The light incident from the back of the TFT substrate (SUB) does not pass through the first assembly electrode 121 and the second conductive layer 722a, which function as a mask, but passes through the transparent second clad material layer 722m, the photosensitive resin PR disposed between the first assembled electrode 121 and the second conductive layer 722a is exposed to light. In this case, the photosensitive resin (PR) may be a negative PR that leaves an area exposed to light during development.

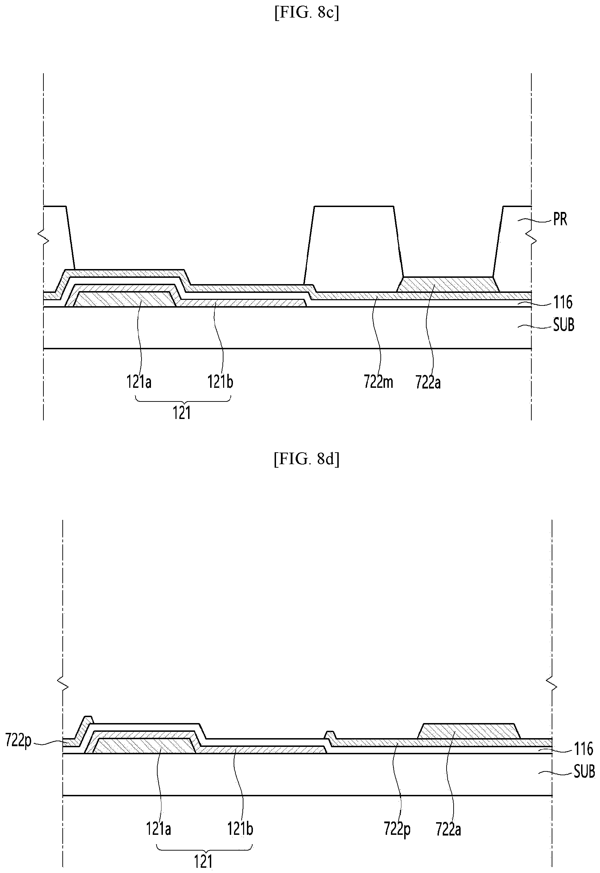

FIG. 8c shows the development stage, in which the photosensitive resin (PR) is removed by washing the area exposed to light while the remaining area is washed with a developer.

FIG. 8d shows the etching and PR peeling step, in which the second clad material layer 722m that does not overlap the photosensitive resin (PR) is removed by etching. The second clad material layer 722m overlapping the first assembly wiring 121 is etched, leaving a second clad patterning layer 722p in an area that does not overlap the first assembly wiring 121. Then, the photosensitive resin (PR) is removed.

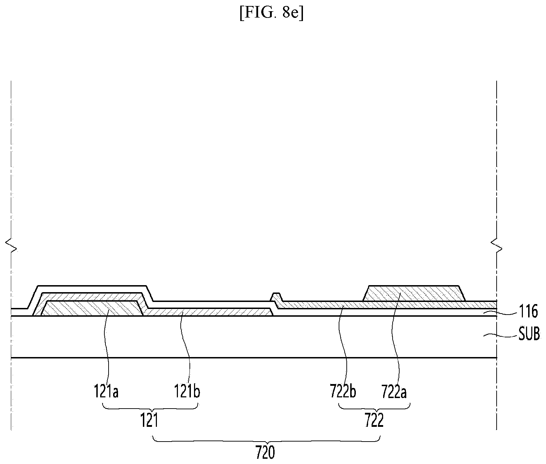

FIG. 8e shows the step of removing part of the second clad patterning layer 722p, the second clad patterning layer 722p that overlaps the second conductive layer 722a or is not between the first assembly wiring 121 and the second conductive layer 722a is removed using a separate mask.

The finally formed second clad layer 722b is formed under the second conductive layer 722a and is electrically connected, and is adjacent to the first clad layer 121b and does not overlap, and the separation distance in the row direction may be adjusted to be zero or very small.

In order to ensure that there is no separation distance from the first clad layer 121b when forming the second clad layer 722b, the amount of exposure to the photosensitive resin PR in FIG. 8b may be adjusted, in some cases, the edge portion of the second clad layer 722b may be formed to span over the first clad layer 121b. It is difficult to say that the second clad layer 722b overlaps the first clad layer 121b and does not affect the assembly rate of the light emitting device 130.

According to the manufacturing method of the display device according to the third embodiment, by forming a transparent third clad layer 123 connected to the second clad layer 122b between the first assembly wiring 121 and the second assembly wiring 122 using back exposure, there is a technical effect of improving the assembly rate of the light emitting device 130 by precisely adjusting the spacing between assembly wirings for assembling the light emitting device 130.

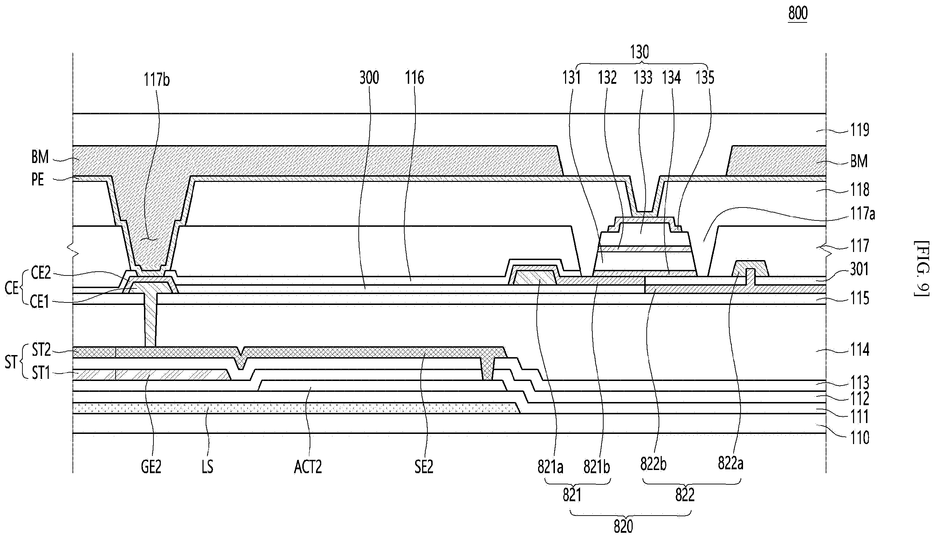

Next, FIG. 9 is a cross-sectional view 800 of a display device according to the fourth embodiment. Hereinafter, the description will focus on the main features of the fourth embodiment.

Referring to FIG. 9, the first assembly wiring 821 and the second assembly wiring 822 may be disposed on the second passivation layer 115. The first assembly wiring 821 includes a first conductive layer 821a and a first clad layer 821b, and the second assembly wiring 822 may include a second conductive layer 822a and a second clad layer 822b.

At this time, the second insulating layer 300 may be disposed between the first assembly wiring 821 and the second passivation layer 115. Additionally, a third insulating layer 301 may be disposed between the second clad layer 822b and the second conductive layer 822a of the second assembly wiring 822. In detail, the second insulating layer 300 may contact the side surface of the second clad layer 822b, and the third insulating layer 301 may contact the side surface of the first clad layer 821b. Additionally, the first clad layer 821b and the second clad layer 822b do not overlap in the vertical or horizontal directions.

At this time, the second clad layer 822b may include a transparent conductive material, and the first clad layer 821b may be in contact with the first electrode 134 of the light emitting device 130 by exposing a portion of the upper surface of the first clad layer 821b in the area of the first opening 117a.

The first clad layer 821b has a large contact area with the light emitting device 130, has excellent electrical signal transmission characteristics, and has the technical effect of supporting the light emitting device 130.

Therefore, by the second insulating layer 300 and the third insulating layer 301, there is a complex technical effect in that the first clad layer 821b and the second clad layer 822b may be placed close to each other without overlapping, thereby improving the DEP force, and the first clad layer may be used as a pixel electrode for driving as well as assembling a light emitting device.

The display device including the semiconductor light emitting device and the manufacturing method thereof according to the above-described embodiment have the technical effect of being able to utilize the wiring for self-assembly of the light emitting device as the wiring for driving the light emitting device.

In addition, the embodiment implements a part of the second assembly wiring using a transparent conductive layer to eliminate the process margin caused by separating the first assembly wiring and the second assembly wiring from each other, there is a technical effect of precisely controlling the gap between the first assembly wiring and the second assembly wiring and improving the transfer rate of the light emitting device.

In addition, the embodiment forms one of the layers constituting the first assembly wiring and the second assembly wiring using a back exposure process, there is a technical effect of precisely adjusting the gap between the first assembly wiring and the second assembly wiring and improving the assembly rate of the light emitting device.

In addition, the embodiment has the technical effect of improving the assembly force of the light emitting device by arranging the first assembly wiring and the second assembly wiring closer together.

The above detailed description should not be construed as restrictive in any respect and should be considered illustrative. The scope of the embodiments should be determined by reasonable interpretation of the appended claims, and all changes within the equivalent scope of the embodiments are included in the scope of the embodiments.

### [Explanation of cited reference]

100, 500, 700, 800: Display device 110: Substrate 111: Buffer layer 112: Gate insulating layer
113: first passivation layer 114: first planarization layer 115: second passivation layer
116: Third passivation layer 117: Second planarization layer 117a: First opening
118: Third planarization layer 119: Protective layer 120, 520, 720, 820: Assembly wiring
121, 821: first assembly wiring 121a, 821a: first conductive layer 121b, 821b: first clad layer
122, 722, 822: second assembly wiring 122a, 722a, 822a: second conductive layer
122b, 722b, 822b: second clad layer 123: third clad layer 130: light emitting device
131: first semiconductor layer 132: light emitting layer 133: second semiconductor layer 134: first electrode
135: second electrode 300: second insulating layer 301: third insulating layer

### [Industrial applicability]

The embodiment may be adopted in the field of displays that display images or information.

The embodiment may be adopted in the field of displays that display images or information using semiconductor light emitting devices.

The embodiment may be adopted in the field of displays that display images or information using micro- or nano-level semiconductor light emitting devices.

## Claims

1. A display device including a semiconductor light emitting device comprising:
a substrate;
a first assembly wiring and a second assembly wiring alternately arranged on the substrate;
a first insulating layer disposed between the first assembly wiring and the second assembly wiring;
a planarization layer disposed on the first assembly wiring and the second assembly wiring and comprising a first opening; and
a light emitting device disposed inside the first opening, including a first electrode to be overlapped with the first assembly wiring and the second assembly wiring,
wherein the first electrode is in contact with one of the first assembly wiring and the second assembly wiring, and
wherein the second assembly wiring comprises a transparent conductive layer.

2. The display device including the semiconductor light emitting device according to claim 1, wherein the first assembly wiring and the second assembly wiring have no separation distance from each other, or the second assembly wiring spans an edge portion of the first assembly wiring.

3. The display device including the semiconductor light emitting device according to claim 1, wherein the first assembly wiring is below the first insulating layer,
wherein the second assembly wiring comprises a second clad layer spaced apart from the first assembly wiring, and a third clad layer in contact with the second clad layer and disposed in the first opening in parallel with the second clad layer or on the second clad layer.

4. The display device including the semiconductor light emitting device according to claim 1,
wherein the first assembly wiring comprises a first conductive layer disposed on the substrate and a first clad layer in contact with the first conductive layer,
wherein the second assembly wiring comprises a second conductive layer disposed on the first insulating layer, a second clad layer in contact with the second conductive layer and a third clad layer in contact with the second clad layer, and
wherein the first electrode is in contact with the third clad layer.

5. The display device including the semiconductor light emitting device according to claim 4, wherein the first conductive layer and the second conductive layer are configured to overlap the planarization layer,
wherein a portion of each of the first clad layer and the second clad layer is disposed inside the first opening, and
wherein the third clad layer is disposed inside the first opening.

6. The display device including the semiconductor light emitting device according to claim 5, wherein the third clad layer is configured to vertically overlap the first clad layer.

7. The display device including the semiconductor light emitting device according to claim 4, wherein the third clad layer is a transparent conductive layer.

8. The display device including the semiconductor light emitting device according to claim 1, wherein the first assembly wiring comprises a first conductive layer disposed on the substrate, and a first clad layer in contact with the first conductive layer, and
wherein the second assembly wiring comprises a second clad layer disposed on the first insulating layer, and a second conductive layer in contact with the second clad layer

9. The display device including the semiconductor light emitting device according to claim 8, wherein the second clad layer is in contact with the first electrode of the light emitting device.

10. The display device including the semiconductor light emitting device according to claim 9, wherein the first conductive layer and the second conductive layer are configured to overlap the planarization layer, and
wherein a portion of each of the first clad layer and the second clad layer is disposed inside the first opening.

11. The display device including the semiconductor light emitting device according to claim 9, wherein the second clad layer is a transparent conductive layer.

12. The display device including the semiconductor light emitting device according to claim 8, wherein the first clad layer is in contact with the first electrode of the light emitting device.

13. The display device including the semiconductor light emitting device according to claim 12, further comprising a second insulating layer in contact with a lower surface of the first clad layer and a side surface of the second clad layer; and a third insulating layer in contact with a upper surface of the second clad layer and a side surface of the first clad layer.

14. The display device including the semiconductor light emitting device according to claim 13, wherein the first clad layer and the second clad layer are configured not to overlap each other in a vertical direction or a horizontal direction.

15. The display device including the semiconductor light emitting device according to claim 13, wherein the third insulating layer is located between the second conductive layer and the second clad layer.

16. A method of manufacturing a display device including a semiconductor light emitting device comprising:
forming a first assembly wiring on a substrate;
forming an insulating layer on the first assembly wiring;
forming a second assembly wiring on the insulating layer to be spaced apart from the first assembly wiring;
forming a planarization layer to expose a portion of the second assembly wiring, and
bonding the light emitting device to be in contact with the second assembly wiring,
wherein the forming the second assembly wiring comprises depositing a transparent conductive layer on the insulating layer, irradiating light from a back of the substrate toward the transparent conductive layer, and removing the transparent conductive layer that is not irradiated with light.

17. The method of manufacturing the display device including the semiconductor light emitting device according to claim 16, wherein the forming the second assembly wiring comprises forming a second conductive layer on the insulating layer, forming a second clad layer completely covering the second conductive layer, and forming a third clad layer through the transparent conductive layer.

18. The method of manufacturing the display device including the semiconductor light emitting device according to claim 17, wherein the second clad layer is configured to have no separation distance from the first assembly wiring and the second clad layer and is configured to contact a side surface of the second clad layer.

19. The method of manufacturing the display device including the semiconductor light emitting device according to claim 16, wherein the forming the first assembly wiring comprises forming a first conductive layer on the substrate, and forming a first clad layer is to completely covered the first conductive layer.

20. The method of manufacturing the display device including the semiconductor light emitting device according to claim 16, wherein forming the second assembly wiring comprises forming a second clad layer through the transparent conductive layer, and forming a second conductive layer on the second clad layer
